# EUROPEAN PATENT APPLICATION

(11) **EP 1 852 899 A1**
(43) Date of publication of application: **07.11.2007**
(21) Application number: 06713170.6
(22) Date of filing: 07.02.2006
(51) Int. Cl.: H01L 21/304, B24B 9/00

(54) **METHOD FOR MANUFACTURING SEMICONDUCTOR WAFER AND METHOD FOR MIRROR CHAMFERING SEMICONDUCTOR WAFER**

(30) Priority: 22.02.2005 JP 2005045360
(71) Applicant: SHIN-ETSU HANDOTAI COMPANY LIMITED, Chiyoda-ku Tokyo 100-0005 (JP)
(72) Inventor: KATO, Tadahiro, Shin-Etsu Handotai Co., Ltd., Nishishirakawa-gun, Fukushima 9618061 (JP); KUDO, Hideo, Shin-Etsu Handotai Co., Ltd., Nishishirakawa-gun, Fukushima 9618061 (JP)
(74) Representative: Wibbelmann, Jobst
(86) International application number: PCT/JP2006/302027
(87) International publication number: WO 2006/090574

(57) **Abstract**

There is provided a semiconductor wafer fabricating method comprising at least: a double-side polishing step of mirror-polishing a front surface and a back surface of a semiconductor wafer; and a mirror edge polishing step of mirror-polishing a chamfered part of the double-side-polished semiconductor wafer, wherein a protection film made of a resin which suppresses polishing is formed on the front surface or both the front and back surfaces of the semiconductor wafer after the double-side polishing step, then the mirror edge polishing step is carried out, and thereafter the protection film made of a resin is removed. As a result, it is possible to provide a step of eliminating an increase in a cost due to, e.g., a facility investment or an increase in the number of steps as much as possible, removing a scratch or an impression on an edge surface of the chamfered part of the semiconductor wafer, and suppressing excessive polishing caused when a polishing pad enters a main surface of the wafer at the mirror edge polishing step of mirror-polishing the chamfered part of the wafer, thereby preventing a wafer outer peripheral shape, especially an edge roll-off from being degraded.

## Description

### TECHNICAL FIELD

The present invention relates to a semiconductor wafer fabricating method, and more particularly to a semiconductor wafer fabricating method and a semiconductor wafer mirror edge polishing method capable of achieving a high flatness degree even at a wafer outer peripheral part when performing fabrication through, e.g., a double-side polishing step.

### BACKGROUND ART

A semiconductor wafer used in fabrication of a semiconductor device is fabricated through each step, e.g., chamfering (grinding), lapping, etching, single-side polishing, or chamfered part polishing (mirror edge polishing) after slicing a silicon single crystal ingot grown by, e.g., a Czochralski method to be machined into a wafer shape.

In recent years, with a reduction in design rules involved by high integration of a semiconductor device, a flatness degree required for a silicon wafer is becoming rigorous. Further, obtaining as many devices as possible from one wafer is desired, and a shape with an entire flat wafer surface, especially a shape that is flat to an outer peripheral end is demanded with an increase in a large diameter of the silicon wafer. A reduction in a so-called outer periphery excluding region where a device chip cannot be obtained at a wafer outer peripheral end advances to 2 mm to from 3 mm which is a conventional value, and a demand for the outer periphery excluding region of 1 mm is coming out. Recently, a flatness degree of a wafer outer peripheral part is evaluated by a parameter called a roll-off amount.

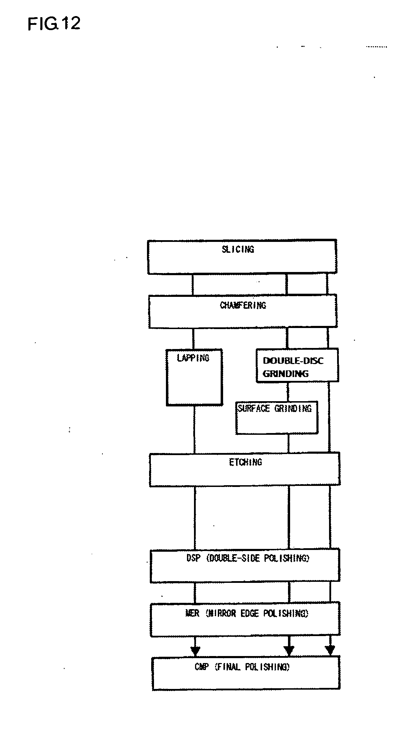

Furthermore, in case of a silicon wafer with a large diameter typified by 300 mmφ which is fabricated to cope with a demand for reducing a manufacturing cost involved by demand expansion of a silicon wafer in recent years, a double-side polishing step of simultaneously polishing front and back surfaces is adopted to obtain a flatness degree quality or a nano-topography quality. Double-side polishing has characteristics that a precision of a flatness degree with respect to a wafer outer peripheral part called an edge roll-off in particular can be readily obtained as compared with single-side polishing. Moreover, it is a machining method having no reference plane, and hence a wavy shape called a nano-topography of 1 mm to 20 mm which is present on front and back surfaces can be easily removed.
In this case, as shown in, e.g., FIG. 12, a silicon wafer having a mirror surface can be obtained through respective steps, i.e., slicing, chamfering, lapping (double-disc grinding, surface grinding), etching, double-side polishing, mirror edge polishing, and final polishing.

Therefore, at the double-side polishing step, since the wafer is held in each of a plurality of circular opening portions in a wafer carrier is polished simultaneously polish both surfaces of the wafer, an edge surface of a chamfered part and a carrier inner peripheral surface of the wafer are always in contact with each other during polishing. Accordingly, a scratch or an impression is formed on an edge surface of the wafer chamfered part, and such a defect cannot be completely avoided even if a resin softer than silicon is used for a carrier inner peripheral surface.

At a film forming step or a resist resin film applying step in device fabrication, an oxide film or a nitride film is formed at a chamfered part or a resist film adheres to the chamfered part in some cases but, if a scratch or an impression is present at the chamfered part, such film components cannot be removed at a subsequent cleaning step and others and remains as a particle generation source, which becomes a factor of degrading a yield. However, when the chamfered part is mirror-polished, resist films or the like adhered thereafter to the chamfered part can be readily removed.

Therefore, after double-side polishing, a mirror edge polishing step of mirror-polishing the chamfered part is required to remove a scratch or an impression on an edge surface of the chamfered part, but a phenomenon that an excellent outer peripheral shape produced by double-side polishing, i.e., an excellent edge roll-off amount is degraded by mirror polishing at the chamfered part occurs. Since a relatively soft polishing pad is used for polishing at the chamfered part, excessive polishing that the polishing pad enters not only the chamfered part but also a front surface and/or a back surface (which will be also referred to as a "main surface" hereinafter) cannot be avoided, thus degrading a roll-off amount.

On the other hand, as a technique of removing a scratch on a chamfered part or an adsorption impression on a back surface, there is proposed a semiconductor wafer manufacturing method comprising: a rough polishing step of inserting/holding a chamfered wafer into a wafer holding hole formed in a wafer holding plate and roughly polishing this semiconductor wafer; a mirror edge polishing step of mirror-finishing a chamfered surface of the semiconductor wafer after rough polishing; and a finish polishing step of finish-polishing the polished surface of the semiconductor wafer after mirror polishing at the chamfered part, wherein an oxide film is formed on the roughly polished semiconductor wafer before polishing the chamfered part, and the oxide film is removed from the semiconductor wafer before performing finish polishing after mirror-polishing the chamfered part (Japanese Patent Application Laid-open No. 2004-87522).

Since the oxide film is used as a protection film in this method, a scratch or an adsorption impression on the chamfered part can be avoided, and excessive polishing with respect to a main surface can be suppressed when mirror-polishing the chamfered part although not explained in Japanese Patent Application Laid-open No. 2004-87522, thereby possibly obtaining an effect of avoiding excessive polishing with respect to the main surface. However, a thermal oxide film by a heat treatment in an oxidizing atmosphere or a vapor growth film by a CVD method is required in this case, but an oxidizing furnace or a CVD furnace is additionally required for formation of such a film, which involves a great facility investment. Further, cleaning using a hydrofluoric acid is required to remove the oxide film after mirror-polishing the chamfered part, and introduction of a special cleaning apparatus is also required.

### DISCLOSURE OF INVENTION

Therefore, in view of the above-explained problems, it is an object of the present invention to provide a step of removing a scratch or an impression on an edge surface of the chamfered part of a semiconductor wafer while eliminating an increase in a cost due to, e.g., a facility investment or an increase in the number of steps as much as possible, and suppressing excessive polishing caused when a polishing pad enters a main surface of the wafer at a mirror edge polishing step of mirror-polishing a chamfered part of the wafer, thereby preventing a wafer outer peripheral shape, especially an edge roll-off from being degraded.

To achieve this object, according to the present invention, there is provided a semiconductor wafer fabricating method comprising at least: a double-side polishing step of mirror-polishing a front surface and a back surface of a semiconductor wafer; and a mirror edge polishing step of mirror-polishing a chamfered part of the double-side-polished semiconductor wafer, wherein a protection film made of a resin which suppresses polishing is formed on the front surface or both the front and back surfaces of the semiconductor wafer after the double-side polishing step, then the mirror edge polishing step is carried out, and thereafter the protection film made of a resin is removed.

As explained above, in the semiconductor wafer fabricating method including at least the double-side polishing step and the mirror edge polishing step, when the protection film made of a resin which suppresses polishing is formed (applied) on the front surface or both the front and back surfaces of the semiconductor wafer after the double-side polishing step, then the mirror edge polishing step is carried out and thereafter the protection film made of the resin is removed, a scratch or an impression on an edge surface of the chamfered part degraded at the double-side polishing step can be readily removed without degrading an highly precise wafer shape obtained by double-side polishing, excessive polishing that a polishing pad enters a main surface of the semiconductor wafer at the mirror edge polishing step can be suppressed, and a wafer outer peripheral shape, especially an edge roll-off is not degraded. Furthermore, since the resin applying step is just added to improve a conventional cleaning step, an increase in a cost due to, e.g., a facility investment or an increase in the number of steps can be eliminated.

At this time, it is preferable to use a silicon wafer as the semiconductor wafer.
A demand for the silicon wafer is highest as a material for a semiconductor device, and double-side polishing is generally carried out in fabrication of a recent mass-produced silicon wafer with a large diameter which is not smaller than 300 mm, and hence the present invention is particularly effective.

Moreover, it is preferable to use a resin which is soluble in an alkaline aqueous solution as the protection film made of a resin.
When a resin which is soluble in an alkaline aqueous solution is used as the protection film made of resin, the protection film made of a resin can be readily removed (delaminated) after the mirror edge polishing step.

Additionally, it is preferable to use a resin having characteristics of exhibiting a polishing rate equal to or slower than a polishing rate of the semiconductor wafer as the protection film made of a resin.
At the mirror edge polishing step, although a silicon surface exposed part and a part covered with the protection film made of resin are simultaneously brought into contact with each other/polished, using a resin having characteristics of exhibiting a polishing rate equal to or slower than a polishing rate of the semiconductor wafer assuredly enables suppressing the part covered with the protection film from being polished by the exposed part, thereby reducing a polishing amount at the time of excessive polishing with respect to the main surface.

Further, it is preferable to use an acrylic resin as the protection film made of resin.
When an acrylic resin is used as the protection film made of resin in this manner, dissolution/decomposition in an alkaline aqueous solution can be facilitated, thereby setting a polishing rate in polishing to be slower than that of the silicon wafer.

Furthermore, it is preferable to perform removal of the protection film made of a resin by alkaline cleaning.
As explained above, the protection film made of a resin can be easily removed by general alkaline cleaning. Moreover, a special solvent is not used in removal of the protection film by such general alkaline cleaning, which is excellent in view of a global environment.

Additionally, it is preferable to perform removal of the protection film made of a resin by chemical cleaning using a mixture of a caustic soda aqueous solution and a hydrogen peroxide solution and chemical cleaning using a mixture of ammonia water and a hydrogen peroxide solution.
When chemical cleaning using a mixture of a caustic soda aqueous solution and a hydrogen peroxide solution is carried out in addition to chemical cleaning using a mixture of ammonia water and a hydrogen peroxide solution, the protection film made of an acrylic resin can be easily removed.

Further, according to the present invention, there is provided a semiconductor wafer mirror edge polishing method of mirror-polishing at least a chamfered part of a semiconductor wafer, wherein a protection film made of a resin which suppresses polishing is formed on a front surface or both front and back surfaces of the semiconductor wafer, and then the mirror edge polishing step is carried out.

As explained above, in the semiconductor wafer mirror edge polishing method, when the protection film made of resin which suppresses polishing is formed on the front surface or both the front and back surfaces of the semiconductor wafer and then the mirror edge polishing step is carried out, a scratch or an impression on an edge surface of the chamfered part can be removed at a low cost, excessive polishing caused when a polishing pad enters a main surface of the wafer can be suppressed at the mirror edge polishing step, and a wafer outer peripheral shape, especially an edge roll-off is not degraded.

Furthermore, it is preferable to remove the protection film made of a resin by cleaning after the mirror edge polishing step.
When the protection film made of a resin is removed by cleaning in this manner after the mirror edge polishing step, the semiconductor wafer can be easily fabricated at a low cost.

Moreover, it is preferable to use a semiconductor wafer subjected to double-side polishing so that the front surface and the back surface are turned to mirror surfaces is used as the semiconductor wafer which is subjected to mirror edge polishing, and form the protection film made of a resin on the semiconductor wafer to perform mirror edge polishing.
As a result, a scratch or an impression on an edge surface of the chamfered part after double-side polishing can be removed at a low cost, excessive polishing caused when the polishing pad enters a main surface of the wafer can be suppressed at the mirror edge polishing step, and a high-precision wafer outer peripheral shape obtained by double-side polishing can be maintained.

As explained above, according to the present invention, an increase in a cost due to, e.g., a facility investment or an increase in the number of steps can be eliminated as much as possible, a scratch or an impression on an edge surface of the chamfered part can be removed as much as possible, and excessive polishing caused when the polishing pad enters the main surface of the wafer can be suppressed at the mirror edge polishing step, thereby configuring a step which does not degrade the wafer outer peripheral shape, especially the edge roll-off.
In particular, just adding the resin applying step to improve the conventional cleaning step enables satisfying a demand from customers for a flatness degree (a roll-off amount) of the wafer outer peripheral part which is expected to increase in future without involving a great change in steps or a facility investment.

### BRIEF EXPLANATION OF THE DRAWINGS

FIG. 1 is a flowchart showing an example of a semiconductor wafer fabricating method according to the present invention;
FIG. 2(A) is a schematic cross-sectional view showing an example of a silicon wafer mirror edge polishing step by a coating method using a protection film made of a resin according to the present invention and a schematic cross-sectional view of the wafer in which the protection film made of a resin is removed after this step, and FIG. 2(B) is a schematic cross-sectional view showing an example of a silicon wafer mirror edge polishing step by a conventional method and a schematic cross-sectional view of the wafer after this step;
FIG. 3 is a schematic view showing an example of a chamfering apparatus;
FIG. 4 is a schematic cross-sectional view showing an example of a double-side polishing apparatus;
FIG. 5 is a schematic plan view showing an arrangement of carriers in the double-side polishing apparatus;
FIG. 6 is a schematic cross-sectional view showing another example of the double-side polishing apparatus;
FIG. 7 is a schematic plan view showing an arrangement of carriers in the double-side polishing apparatus depicted in FIG. 6;
FIG. 8 is a schematic view showing an example of a polishing method for a chamfered part;
FIG. 9 is a schematic view showing another example of the polishing method for the chamfered part;
FIG. 10 is a schematic view showing still another example of the polishing method for the chamfered part;
FIG. 11 is a graph showing roll-off amounts based the conventional method and a coating method according to the present invention;
FIG. 12 is a flowchart showing an example of conventional silicon wafer fabrication steps;
FIG. 13 is a view showing an excessively polished region observed by a microscope;
FIG. 14 is a schematic view showing an example of cells in evaluation of site flatness;
FIG. 15 is a graph showing a roll-off amount; and
FIG. 16 is an explanatory drawing showing a roll-off measurement principle.

### BEST MODES FOR CARRYING OUT THE INVENTION

Although the present invention will now be specifically explained hereinafter with reference to the attached drawings, the present invention is not restricted thereto.
With high integration and an increase in demand for a semiconductor device in recent years, a silicon wafer having a shape with an entire flat wafer surface, especially a flat outer peripheral part as well as an increase in a large diameter of the silicon wafer is demanded, and the present inventors positively studied to meet this demand.
In this study, the present inventors examined a outer peripheral shape of a silicon wafer when the wafer is subjected to double-side polishing and then a chamfered part is polished.

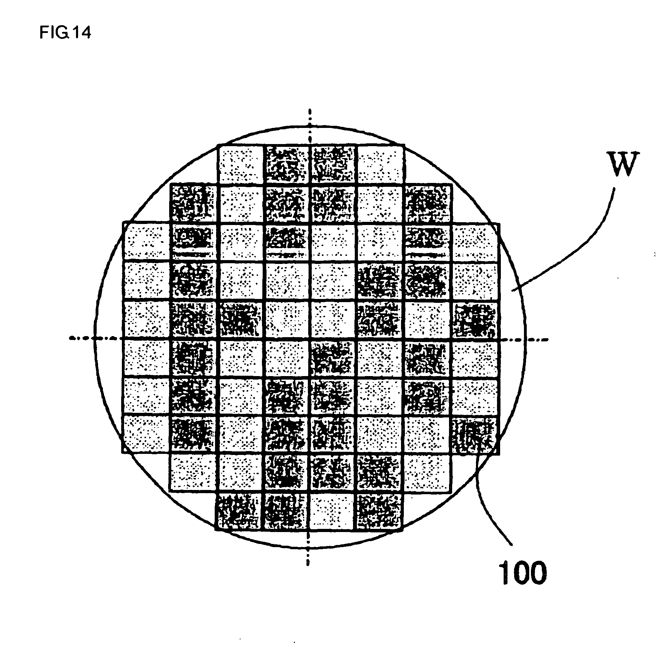

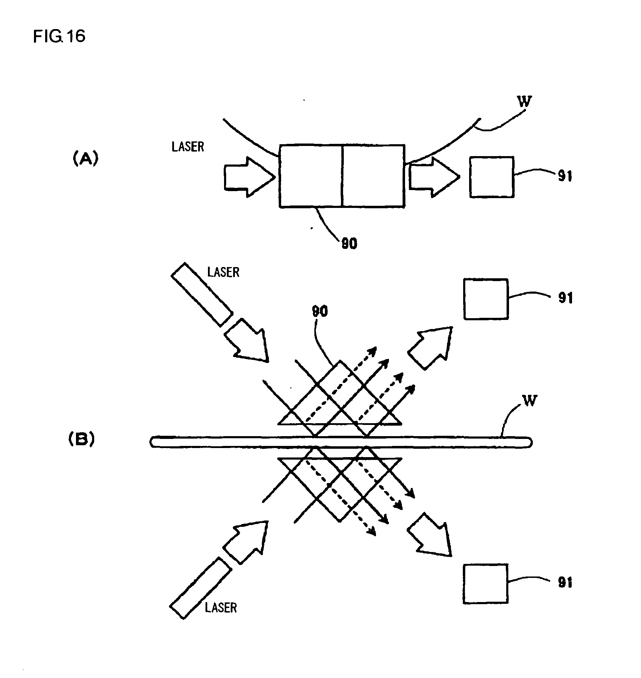

When evaluating a flatness degree of the wafer, in site flatness defined by SFQR or SBIR which is conventionally carried out, since the wafer is divided into such cells 100 each having a predetermined size as shown in FIG. 14 to perform evaluation, an outer peripheral shape near a chamfered part cannot be accurately grasped.
Thus, in recent years, an evaluation reference called rolled-off has been adopted in order to precisely evaluate the outer peripheral shape of the wafer. A parameter called roll-off enables directly measuring a shape of the outer peripheral part of the wafer and highly precisely performing evaluation. It is to be noted that a standardization organization examines standardization of a definition of the roll-off, but there is, e.g., a method of applying a laser beam to a wafer surface through a prism 90 and receiving a reflected light by using a CCD 91 to effect measurement as shown in FIG. 16. Furthermore, a reference line is calculated from a surface profile, and a roll-off amount can be obtained as a reference from the reference line.

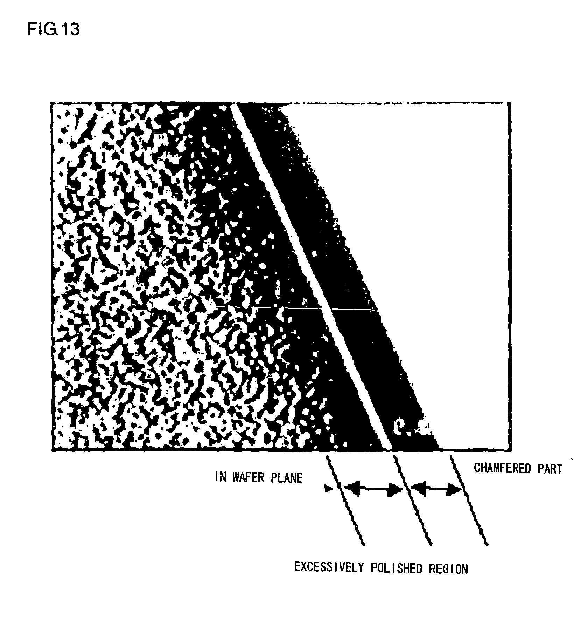

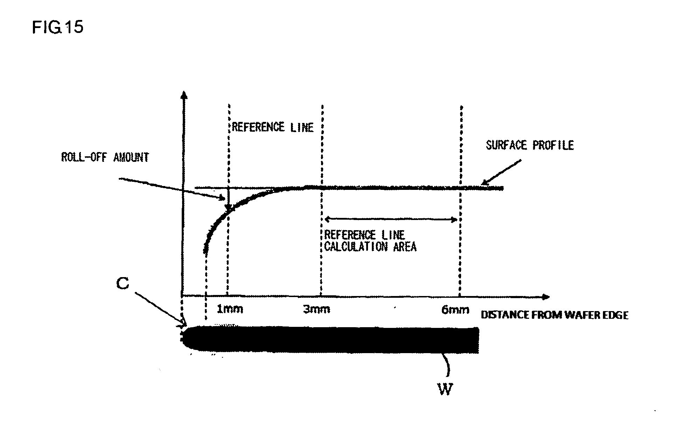

When the present inventors performed double-side polishing to a silicon wafer and further polished a chamfered part to measure a roll-off amount, such a result as shown in FIG. 15 was obtained. Here, it was found that a width of the chamfered part C is not greater than approximately 0.3 mm but a roll-off amount on a main surface near the chamfered part is large.
Moreover, when a position near a boundary between the chamfered part and the main surface after the chamfered part polishing was observed by using a microscope, an excessively polished region in the wafer surface beyond the boundary from the chamfered part was discovered as shown in FIG. 13.
According to such examination results, it was revealed that degradation in flatness (roll-off) due to excessive polishing at the time of polishing the chamfered part is considerable.

Thus, the present inventors positively studied about a method of effectively avoiding the excessive polishing, thereby bringing the present invention to completion.
That is, in a semiconductor wafer fabricating method including at least a double-side polishing step of mirror-polishing a front surface and a back surface of a semiconductor wafer and a mirror edge polishing step of mirror-polishing a chamfered part of the semiconductor wafer subjected to double-side polishing, the present inventors revealed that a scratch or an impression on an edge surface of the chamfered part after double-side polishing can be removed while eliminating an increase in a cost due to, e.g., a facility investment or an increase in the number of steps as much as possible, excessive polishing caused when a polishing pad enters a main surface of the wafer can be suppressed at the mirror edge polishing step, and a wafer outer peripheral shape, especially an edge roll-off is not degraded when a protection film made of a resin which suppresses polishing is formed on the front surface or both the front and back surfaces of the semiconductor wafer after the double-side polishing step, then the mirror edge polishing step is effected, and thereafter the protection film made of a resin is removed.

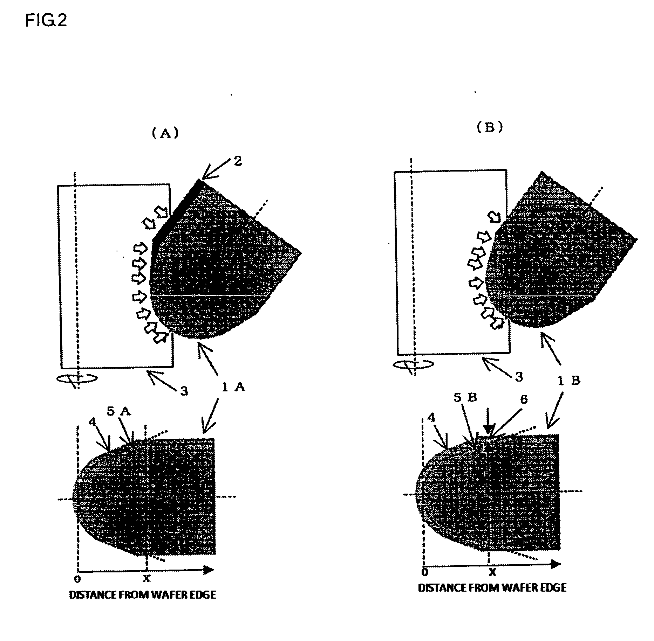

The present invention will be first explained with reference to schematic views of FIGs. 2. FIG. 2(A) is a schematic cross-sectional view showing an example of a silicon wafer mirror edge polishing step by a coating method using a protection film made of a resin according to the present invention and a schematic cross-sectional view of the wafer in which the protection film made of resin is removed after this step, and FIG. 2(B) is a schematic cross-sectional view showing an example of a silicon wafer mirror edge polishing step by a conventional method and a schematic cross-sectional view of the wafer before and after the mirror edge polishing step. In the coating step according to the present invention, a protection film 2 made of a resin which suppresses polishing is formed on a front surface or both front and back surfaces of a semiconductor wafer after a double-side polishing step, then a mirror edge polishing step is carried out, and thereafter the protection film 2 made of a resin is removed. As a result, excessive polishing is carried out from a shape 4 before polishing to a shape 5B after polishing in the conventional method, whereas polishing is just carried out from the shape 4 before polishing to a shape 5A after polishing in the coating method according to the present invention since the main surface is protected by the protection film 2, thus suppressing excessive polishing caused when a polishing pad enters the main surface of the wafer at the mirror edge polishing step.

Specifically, for example, when the coating method according to the present invention is compared with the conventional method in a predetermined distance X from a wafer edge, a roll-off amount 6 indicated by arrows is large in the conventional method, whereas the roll-off amount can be reduced or suppressed to substantially zero in the coating method according to the present invention as shown in FIG. 2(A).

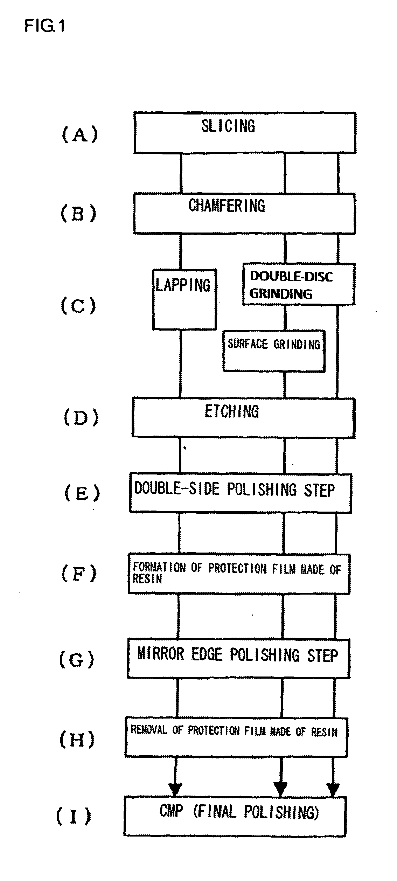

An embodiment according to the present invention will now be explained hereinafter in a time-series order with reference to the drawings.
First, a silicon single crystal ingot grown by, e.g., a Czochralski method (a CZ method) or a floating zone melting method (a FZ method) is sliced into a wafer shape by using, e.g., a wire saw (FIG. 1(A)).

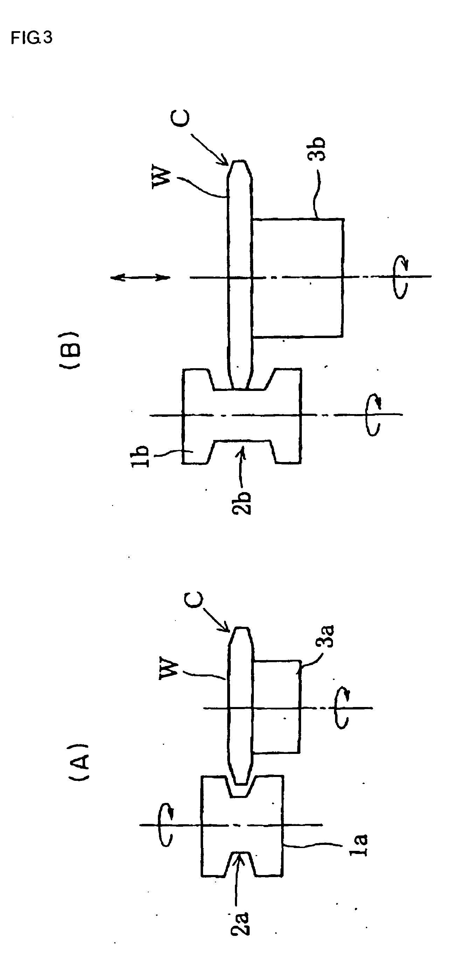

Then, chamfering of removing a corner of a periphery of the wafer by grinding is carried out to avoid chips or cracks at the outer periphery of the wafer (FIG. 1(B)).
As to chamfering, for example, as shown in FIG. 3, a wafer outer peripheral edge is pressed against a groove 2a of a grind stone 1a having the same shape as a desired wafer chamfered shape, and upper and lower corners and an outermost peripheral part (an edge surface) of a wafer W held on a holding plate 3a are simultaneously chamfered, thereby forming a chamfered part C.

Further, as shown in FIG. 3(B), a relative position of a wafer W and a grind stone is subjected to numerical control, the grind stone 1b with a groove 2b having an inverted trapezoidal shape can be used to grind an outermost peripheral part (an edge surface) of the wafer held on a holding plate 3b, an upper tapered surface of the groove 2b can be used to chamfer a corner of the wafer W on an upper surface side, and a lower tapered surface of the groove 2b can be used to chamfer a corner of the wafer W on a lower surface side.

After chamfering, lapping is carried out to uniform a thickness and increase a flatness degree of the wafer (FIG. 1(C)).
It is to be noted that lapping may be carried out before chamfering. Furthermore, in place of lapping, a pair of grind stones for grinding may be used to perform duplex grinding of simultaneously grinding both surfaces of the wafer, or surface grinding of grinding surfaces of the wafer fixed on the holding plate side by side by using a grind stone may be carried out. Both the duplex grinding an the surface grinding can be effected.

In order to remove a processing damage produced on the surface of the wafer due to, e.g., lapping, the wafer is dipped in an etchant and etched (FIG. 1(D)).
For example, alkali etching using an aqueous solution, e.g., a sodium hydroxide or a potassium hydroxide or acid etching using a mixture of a hydrofluoric acid and a nitric acid can be carried out.

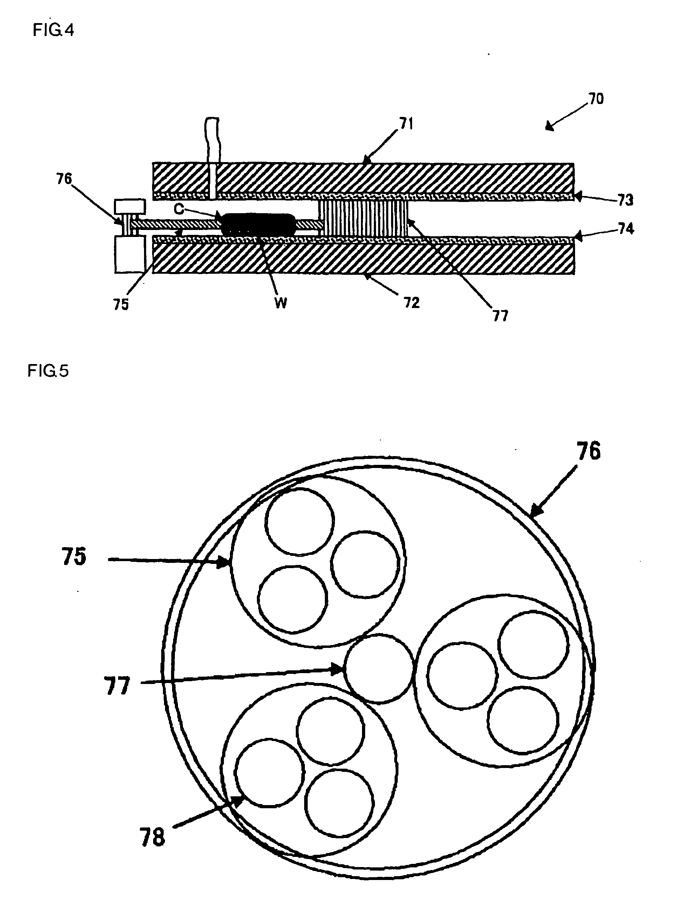

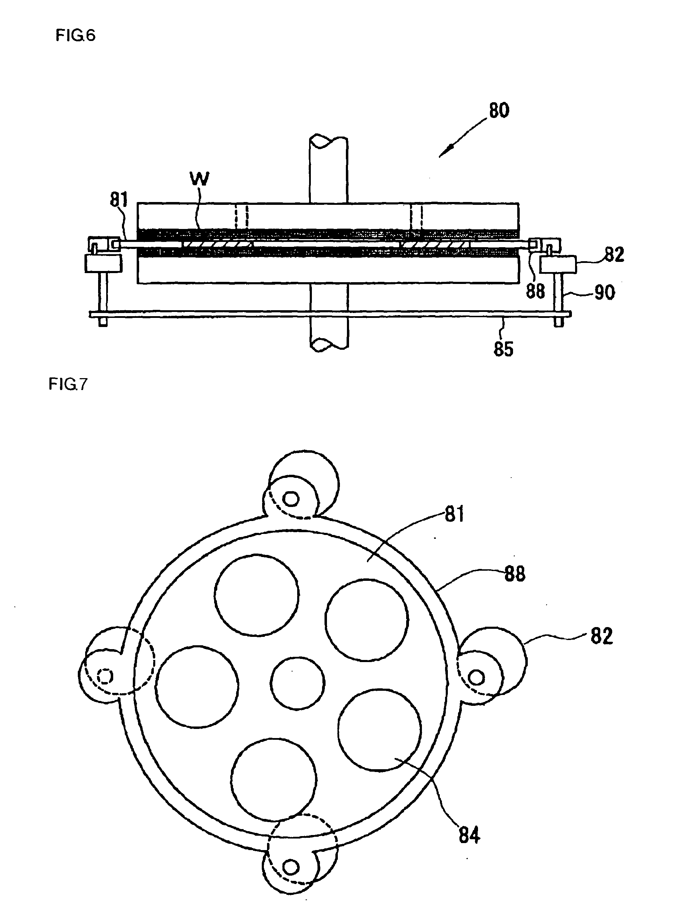

Then, a double-side polishing step of mirror-polishing the front surface and the back surface of the semiconductor wafer is effected (FIG. 1(E)). The double-side polishing step is carried out by using, e.g., such an apparatus 70 as depicted in FIG. 4. In this apparatus 70, the wafer W is held in each circular hole 78 in such a carrier 75 as shown in FIG. 5, it is sandwiched between a pair of upper and lower turn table 71 and 72 to which polishing pads 73 and 74 are bonded, a polishing slurry is supplied, and an internal gear 76 and a sun gear 77 are used to rotate the carrier 75, thereby simultaneously polishing both surfaces of the wafer W. When the carrier 75 is rotated, both surfaces of the wafer W can be simultaneously polished.

Furthermore, for example, a double-side polishing apparatus 80 as depicted in FIGS. 6 and 7 can be also used. In this apparatus 80, at the time of polishing, when all eccentric arms 82 are rotated around a rotary shaft 90 through a timing chain 85 in synchronization with each other, a carrier 81 held in a carrier holder 88 circulates to describe a small circle within a horizontal plane without rotation on its axis. Since such an oscillation type double-side polishing apparatus 80 can be reduced in size, a wafer with a large diameter can be polished in a relatively narrow space. With an increase in a diameter of a wafer in recent years, such an oscillation type double-side polishing apparatus 80 is often used.

When such double-side polishing is performed, surface roughness of the wafer W is improved and a flatness degree can be enhanced, but a periphery (the chamfered part C) of the wafer W comes into contact with an inner surface of the circular hole 78 or 84 in the carrier 75 or 81 and a scratch or an impression is produced at the chamfered part C of the wafer W when double-side polishing is performed in this manner.
In order to remove, e.g., such a scratch, although a mirror edge polishing step of mirror-polishing the chamfered part C of the wafer W subjected to double-side polishing is carried out, a protection film made of a resin which suppresses polishing is formed (applied) on the front surface of both the front and back surfaces of the semiconductor wafer before this mirror edge polishing step in the present invention (FIG. 1(F)).

As the protection film made of a resin which suppresses polishing, an acrylic resin that is a resin which is soluble in an alkaline aqueous solution and has characteristics slower than a polishing rate of a silicon wafer is used. When the acrylic resin is used, it can be readily dissolved/decomposed in the alkaline aqueous solution, and a polishing rate at the time of polishing can be set slower than that of the silicon wafer.

Although the protection film made of a resin which suppresses polishing is not restricted to the acrylic resin, it is preferable to use a resin which is soluble in an alkali wafer solution and has characteristics equal to or slower than the polishing rate of the silicon wafer. Using the resin that is soluble in the alkaline aqueous solution as the protection film made of a resin enables facilitating removal of the protection film made of a resin after the mirror edge polishing step, and using the resin having characteristics equal to or slower than the polishing rate of the silicon wafer as the protection film made of resin enables suppressing excessive polishing with respect to the main surface at the next mirror edge polishing step since a part covered with the protection film made of a resin is hardly polished as compared with a silicon exposed surface when the covered part and the exposed part are simultaneously brought into a contact and a polish.

In order to form the protection film on the wafer, for example, fluidity is provided to an acrylic resin by using alcohol as a solvent, and this material is applied to the surface by a spin coater. At this moment, a spin rotation is set high to prevent the resin from being applied to an edge surface of the chamfered part, and the next mirror edge polishing step is performed after baking/drying. The protection film forming method is not restricted to the spin coater, and a generally used method, e.g., application using a brush can be adopted.

Even if the protection film is formed on a surface alone where the roll-off becomes a problem, an improvement effect can be obtained as compared with the conventional technique, but forming the protection film on both the front and back surfaces enables further improving the outer peripheral shape. When forming the protection film on both surfaces, for example, it is good enough to coat one surface with the protection film, turn over the wafer after baking, coat the back surface with the protection film, and carry out the mirror edge polishing step after baking.

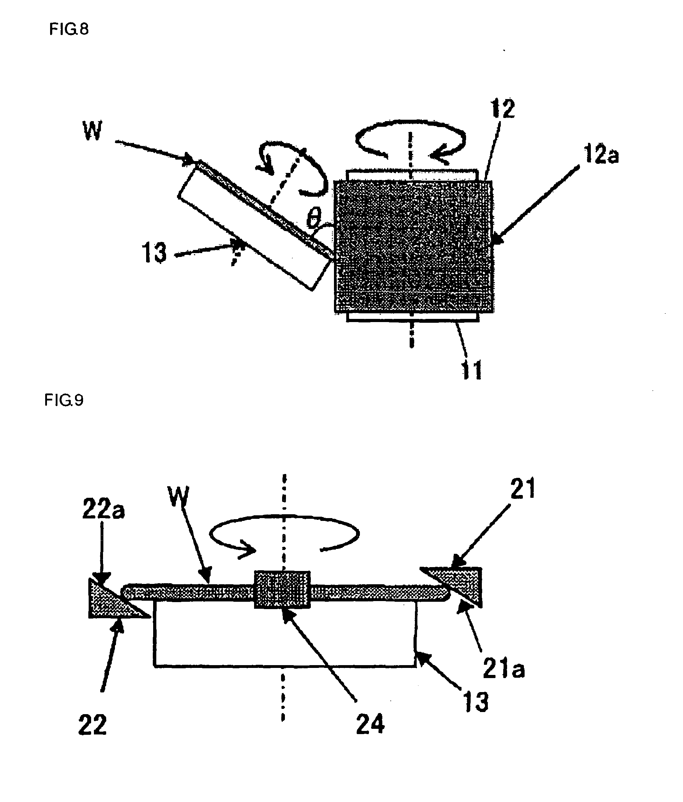

Then, the mirror edge polishing step of mirror-polishing the chamfered part C of the wafer W which has been subjected to double-side polishing and has the protection films formed thereon is carried out (FIG. 1(G)).
The wafer W which has the protection film made of an acrylic resin applied to the surface thereof and has an edge surface of the chamfered part having no protection film applied thereto is subjected to mirror polishing. This mirror edge polishing step enables preferentially polishing an edge surface of the chamfered part, thereby avoiding polishing the main surface.
For mirror polishing with respect to the chamfered part C, various kinds of generally proposed polishing methods or polishing apparatuses are utilized. For example, as shown in FIG. 8, there is a method of holding the wafer W by a vacuum chuck stage 13, pressing the chamfered part of the wafer W inclined with respect to a polishing surface 12a against a rotary drum 11 having a polishing pad 12 bonded to an outer periphery thereof under a fixed pressure, and polishing the chamfered part while supplying a polishing slurry containing, e.g., a colloidal silica.

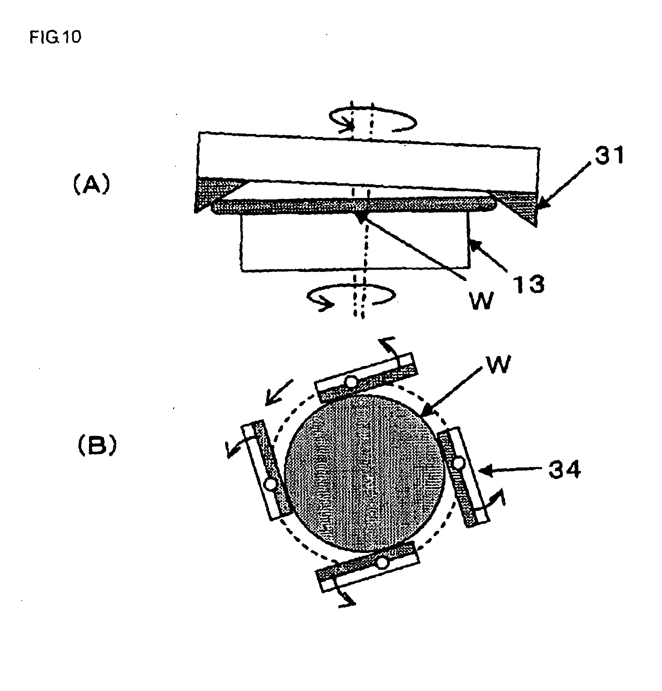

Furthermore, there is a method of pressing polishing pads 21 and 22 respectively having inclined polishing surfaces 21a and 22a and a polishing pad 24 having a vertical surface against the chamfered part of the wafer W which is held and rotated on the a vacuum chuck stage 13 and polishing the entire chamfered part as shown in FIG. 9, or a method of pressing an inverted-cup-like polishing pad 31 against the chamfered part of the wafer W to polish a chamfered surface of the chamfered part on a main surface side and then pressing each polishing pad 34 vertical to an edge surface (an outermost peripheral surface) to polish the edge surface of the chamfered part as shown in FIGS. 10(A) and (B).

After such a mirror edge polishing step, removal of the protection film made of a resin (FIG. 1(H)) is carried out by alkaline cleaning.
The protection film made of a resin can be readily removed by general alkaline cleaning, and this method is excellent in view of a global environment since a special solvent is not used. In particular, it is preferable to remove the protection film by chemical cleaning using a mixture of a caustic soda aqueous solution and a hydrogen peroxide solution and chemical cleaning using a mixture of ammonia water and a hydrogen peroxide solution, and chemical cleaning using the mixture of the caustic soda aqueous solution and the hydrogen peroxide solution enables removing the protection film made of an acrylic resin and then chemical cleaning using the mixture of ammonia water and the hydrogen peroxide solution enables general cleaning after a general edge polishing step. That is, as to removal of the protection film, just adding chemical cleaning using the mixture of the caustic soda aqueous solution and the hydrogen peroxide solution to a generally performed cleaning step can suffice.

Moreover, after removing the protection film made of a resin, final polishing is carried out (FIG. 1(I)). According to such final polishing, for example, one surface of the wafer can be adsorbed and held, and the one side alone where a device is to be formed can be subjected to single-side polishing while supplying a polishing slurry. The wafer may be bonded to a plate through an adhesive, e.g., a wax to carry out single-side polishing. It is to be noted that, when stock removal is increased in this final polishing, a flatness degree in an outer peripheral region of the wafer may be possibly degraded, and hence setting the stock removal to 2 µm or below, especially 1 µm is preferable.

When the silicon wafer is fabricated through the above-explained steps, an increase in a cost due to, e.g., a facility investment or an increase in the number of steps can be eliminated as much as possible, a scratch and others formed on an edge surface of the chamfered part at the double-side polishing step can be removed, the main surface near the chamfered part can be prevented from excessively polished, the wafer outer peripheral shape, especially the edge roll-off is not degraded, and hence the highly flattened mirror-surface silicon wafer in which flatness obtained by double-side polishing is maintained can be fabricated, thus contributing to, e.g., an improvement in productivity and a yield of a device chip obtained from one wafer.

Although the present invention will now be specifically explained hereinafter with reference to an example and a comparative example, the present invention is not restricted thereto.

### (Example)

Such a double-side polishing apparatus as depicted in FIG. 6 was used to perform double-side polishing with respect to a silicon wafer having a diameter of 300 mm obtained by sequentially effecting respective processes, i.e., slicing, chamfering, lapping, and etching.
After double-side polishing, an acrylic resin (a product name: Sky Coat manufactured by Nikka Seiko Co., Ltd.) was applied by using a spin coater to form protection films each having a thickness of approximately 3 µm on both surfaces of the wafer W. At this time, the number of revolutions of the spin coater was determined as 1200 rpm, the protection films were formed on the main surfaces alone of the front and back surfaces, and the protection film was prevented from being formed on a wafer edge surface. Then, a chamfered surface on each main surface side at a chamfered part of the wafer W was brought into contact with a polishing pad to mirror-polish the chamfered part (FIG. 2(A): the protection film is shown on one surface alone in the drawing for convenience's sake).

At this mirror edge polishing step, an IV type mirror edge polishing apparatus manufactured by SpeedFam Co., Ltd was used, the wafer W was held by an vacuum chuck stage 13 with respect to a polishing surface of the polishing pad as shown in FIG. 8, and the inclined chamfered part of the wafer W was pressed against a rotary drum 11 having the polishing pad 12 bonded to an outer periphery thereof under a fixed pressure to mirror-polish the chamfered part. SUBA400 manufactured by Rodel Inc. was used as the polishing pad, a polishing slurry in which AJ1325 manufactured by Nissan Chemical Industries, Ltd. is contained as a base and adjusted to pH 11.0 was supplied with a flow rate of 2 liters/minute as a polishing agent, and the chamfered part was polished with a polishing load being set to 2.0 kgf.

Then, the protection films made of the acrylic resin were removed by chemical cleaning using a mixture of a caustic soda aqueous solution and a hydrogen peroxide solution ((a volume ratio) 48% of the caustic soda aqueous solution: 20% of the hydrogen peroxide solution: pure water = 1:1:10) and chemical cleaning using a mixture of ammonia water and the hydrogen peroxide solution ((a volume ratio) 30% of the ammonia water: 20% of the hydrogen peroxide solution: pure water = 1:1:10), and thereafter a single-side polishing apparatus was used to perform final polishing to one surface of the wafer W. In this final polishing, a slurry equal to that used at the mirror edge polishing step was supplied to perform polishing in such a manner that stock removal becomes approximately 1 µm.

After the final polishing, a roll-off amount was measured. For roll-off measurement, such a roll-off measuring apparatus (LER-310M manufactured by Kobelco Research Institute, Ltd.) as shown in FIG. 16 was used. As measurement conditions, a reference extrapolation line obtained by calculating a region that is 3 mm to 6 mm from the wafer edge by a least square method was determined as a reference to measure a roll-off amount at a position that is 1 mm from the wafer edge.

### (Comparative Example)

Like Example, polishing was performed with respect to a chamfered part of a wafer W obtained by sequentially effecting respective processes, i.e., slicing, chamfering, lapping, etching, and double-side polishing without forming a protection film. The chamfered part was polished by using a mirror edge polishing apparatus (an IV type manufactured by SpeedFam Co., Ltd.) having polishing pads bonded to a circumference of a rotary drum depicted in FIG. 8. After polishing the chamfered part, like Example, one surface of the wafer W was subjected to final polishing.
After the final polishing, a roll-off amount of the wafer W was measured.

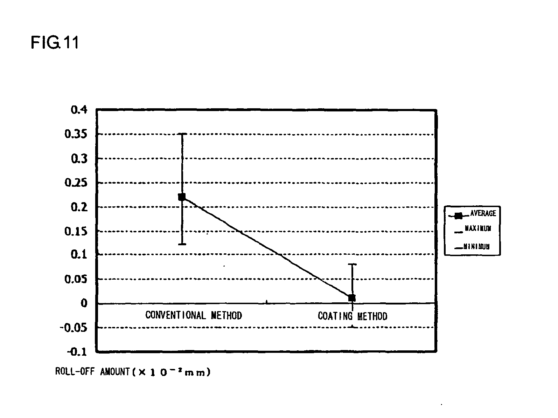

Table 1 and FIG. 11 show results of the roll-off amounts measured in Example and Comparative Example as the coating method according to the present invention and the conventional method, respectively.

**[Table 1]**

| | Coating method | Conventional method |
|---|---|---|
| Average | 0.01 | 0.22 |
| Maximum | 0.08 | 0.35 |
| Minimum | -0.05 | 0.12 |

After the final polishing, according to the conventional method of Comparative Example, the roll-off amount (an average value) was as large as 0.22×10⁻² mm. On the other hand, according to the coating method of Example, the roll-off amount was 0.01×10⁻² mm which is substantially zero. As explained above, it was revealed that the present invention is excellent without degrading the wafer outer peripheral shape, especially the edge roll-off.

Incidentally, presence/absence of a scratch or an impression at the chamfer part was examined by visual examination with respect to each mirror-surface wafer obtained by Example or Comparative Example, and the level of presence/absence of a scratch and others was the same, and it was found that the present invention enables eliminating an increase in a cost due to, e.g., a facility investment or an increase in the number of steps and removing a scratch or an impression on an edge surface of the chamfered part after double-side polishing, and suppressing excessive polishing caused when the polishing pad enters the main surface of the wafer at the mirror edge polishing step, thereby preventing the wafer outer peripheral shape, especially the edge roll-off from being degraded.

It is to be noted that the present invention is not restricted to the foregoing embodiment. The foregoing embodiment is just an example, and any example which has substantially the same structure as a technical concept described in claims of the present invention and demonstrates the same functions and effects is included in a technical scope of the present invention.
For example, although fabrication of the silicon wafer has been explained in the foregoing embodiment, the present invention can be also applied to fabrication of any other semiconductor wafer.

Moreover, the present invention is not restricted to the fabrication steps explained in the foregoing embodiment, and a heat treatment step may be added, or an already chamfered wafer may be prepared and subjected to the double-side polishing step, formation of the protection film made of a resin, the mirror edge polishing step, and removal of the protection film made of a resin according to the present invention, for example.

Additionally, the present invention is not restricted to the above-explained fabrication method for the silicon wafer, and it can be likewise applied to a mirror edge polishing method for a semiconductor wafer.
Specifically, the present invention can be applied to the semiconductor wafer mirror edge polishing method of mirror-polishing at least a chamfered part of the semiconductor wafer, wherein a protection film made of a resin which suppresses polishing is formed on a front surface or both front and back surfaces of the semiconductor wafer, and then the mirror edge polishing step is carried out.
In this case, it is preferable to clean the protection film made of a resin after the mirror edge polishing step, and it is further preferable to use a semiconductor wafer subjected double-side polishing so that both front and back surfaces thereof are turned to mirror surfaces as the semiconductor wafer that is a target of mirror edge polishing and form the protection film made of a resin to the semiconductor wafer to perform mirror edge polishing.

That is, like the present invention, the method of improving a roll-off of a wafer outer periphery by mirror edge polishing in which the protection film is formed and then the chamfered part is mirror-polished can be applied to any case where a chamfered part of a semiconductor wafer is mirror-polished as a general rule.
The present invention can be necessarily applied not only a double-side-polished semiconductor wafer but also a single-side-polished semiconductor wafer.

## Claims

1. A semiconductor wafer fabricating method comprising at least: a double-side polishing step of mirror-polishing a front surface and a back surface of a semiconductor wafer; and a mirror edge polishing step of mirror-polishing a chamfered part of the double-side-polished semiconductor wafer, wherein a protection film made of a resin which suppresses polishing is formed on the front surface or both the front and back surfaces of the semiconductor wafer after the double-side polishing step, then the mirror edge polishing step is carried out, and thereafter the protection film made of a resin is removed.

2. The semiconductor wafer fabricating method according to claim 1, wherein a silicon wafer is used as the semiconductor wafer.

3. The semiconductor wafer fabricating method according to claim 1 or 2, wherein a resin which is soluble in an alkaline aqueous solution is used as the protection film made of a resin.

4. The semiconductor wafer fabricating method according to any one of claims 1 to 3, wherein a resin having characteristics of exhibiting a polishing rate equal to or slower than a polishing rate of the semiconductor wafer is used as the protection film made of a resin.

5. The semiconductor wafer fabricating method according to any one of claims 1 to 4, wherein an acrylic resin is used as the protection film made of a resin.

6. The semiconductor wafer fabricating method according to any one of claims 1 to 5, wherein the protection film made of a resin is removed by alkaline cleaning.

7. The semiconductor wafer fabricating method according to any one of claims 1 to 6, wherein the protection film made of a resin is removed by chemical cleaning using a mixture of a caustic soda aqueous solution and a hydrogen peroxide solution and chemical cleaning using a mixture of ammonia water and the hydrogen peroxide solution.

8. A semiconductor wafer mirror edge polishing method of mirror-polishing at least a chamfered part of a semiconductor wafer, wherein a protection film made of a resin which suppresses polishing is formed on a front surface or both front and back surfaces of the semiconductor wafer, and then the mirror edge polishing step is carried out.

9. The semiconductor wafer mirror edge polishing method according to claim 8, wherein the protection film made of a resin is removed by cleaning after the mirror edge polishing step.

10. The semiconductor wafer mirror edge polishing method according to claim 8 or 9, wherein a semiconductor wafer subjected to double-side polishing so that the front surface and the back surface are turned to mirror surfaces is used as the semiconductor wafer which is subjected to mirror edge polishing, and the protection film made of a resin is formed on the semiconductor wafer to perform mirror edge polishing.
